# EUROPÄISCHE PATENTSCHRIFT

(11) **EP 1 729 555 B1**
(45) Veröffentlichungstag und Bekanntmachung des Hinweises auf die Patenterteilung: **02.01.2008**
(21) Anmeldenummer: 05011726.6
(22) Anmeldetag: 31.05.2005
(51) Int. Cl.: H05K 3/36, H05K 1/14

(54) **Verfahren zur Herstellung einer Leiterplatte und eines Leiterplattensystems sowie mittels solcher Verfahren hergestellte Leiterplattten und Leiterplattensysteme**
Method for manufacturing a circuit board and a system of circuit boards as well as a circuit board and a system of circuit boards made by the methods
Procédé de production d'une carte à circuits imprimés et d'un système de cartes à circuits imprimés et carte à circuits imprimés et système de cartes à circuits imprimés produits avec ces procédés

(43) Veröffentlichungstag der Anmeldung: 06.12.2006
(73) Patentinhaber: SIEMENS AKTIENGESELLSCHAFT, 80333 München (DE)
(72) Erfinder: Fischer, Alfred, 92421 Schwandorf (DE); Gubisch, Thomas, 92245 Kümmersbruck (DE); Niebler, Günther, 92260 Ammerthal (DE); Teichrieb, Eugen, 92224 Amberg (DE)

(56) Entgegenhaltungen:
- EP-A- 0 766 507
- DE-A1- 4 236 268
- JP-A- 59 186 387
- PATENT ABSTRACTS OF JAPAN Bd. 014, Nr. 391 (E-0968), 23. August 1990 (1990-08-23) & JP 02 144991 A (HITACHI DENSHI LTD), 4. Juni 1990 (1990-06-04)

## Beschreibung

Die Erfindung betrifft ein Verfahren zur Herstellung einer ersten und zweiten Leiterplatte, welche zur Aufnahme einer weiteren Leiterplatte bestimmt ist, wobei das Verfahren u.a. Schritte zur Aufbringung von Kontaktierungsflächen auf der ersten bzw. zweiten Leiterplatte einschließt. Die Erfindung betrifft weiterhin eine erste und eine zweite Leiterplatte bzw. ein erstes und ein zweites Leiterplattensystem, welche auf Basis der oben genannten Verfahren hergestellt sind.

Eine Leiterplatte, auch Platine oder gedruckte Schaltung, dient dem Verbinden von elektrischen und elektronischen Bauteilen ohne die Verwendung von herkömmlichen Kabeln. Einfache Leiterplatten bestehen aus einer Kupferschicht, die auf einem Kunststoffträger aufgebracht ist. Als Kunststoffträger wird meistens eine mit Epoxidharz getränkte Glasfasermatte oder ein Kunststoffträger aus Pertinax verwendet. Eine solche Leiterplatte weist typischerweise eine Dicke von ca. 1,6 mm auf. Die Herstellung der Leiterbahnen erfolgt, in dem lichtempfindlicher Fotolack durch eine Maske belichtet wird. Anschließend werden die so maskierten Zwischenräume durch nasschemische Prozesse freigeätzt. Ebenso können Kupferschichten verdickt bzw. zusätzliche metallische Schutzschichten aus Nickel, Gold, usw. durch galvanische Prozesse aufgebracht werden. Meistens wird noch ein Lötstopplack auf die Leiterplatte aufgebracht, der die Leiterbahnen abdeckt und nur die Lötstellen frei lässt.

Aus Gründen der Platzersparnis sowie aus Kostengründen ist es auch möglich, weitere Leiterplatten mit elektronischen Bauelementen senkrecht zur Leiterplatte anzuordnen. Dazu weisen die weiteren Leiterplatten vorzugsweise eine Klemmleiste mit Anschlusskontakten in Reihenform auf. Die Klemmleiste kann dann in eine entsprechende Buchsenleiste auf der ersten Leiterplatte eingesteckt werden oder direkt in eine Aussparung auf der ersten Leiterplatte gesteckt und mit dieser verlötet werden. Eine Leiterplatte entsprechend dem letzteren Fall wird auch als Grundleiterplatte oder Mutterleiterplatte bezeichnet. Die weitere Leiterplatte wird als Tochterleiterplatte bezeichnet. Beide Leiterplatten sind zum einen mechanisch derart miteinander zu verbinden, dass ein Verkippen, Verdrehen oder ein Herausfallen der Tochterleiterplatte aus der Mutterleiterplatte verhindert wird. Zum anderen sind die beiden Leiterplatten miteinander elektrisch leitend zu verbinden. Um dabei die mechanische Stabilität und elektrische Leitfähigkeit zu gewährleisten, sind entsprechende Maßnahmen zu treffen; vgl. dazu z.B. DE 4 236 268 A1.

Aus der EP 0 766 507 A1 ist eine Leiterplatte bekannt, die eine längliche Öffnung zur Aufnahme eines Endes eines Moduls aufweist. Die Außenseiten der länglichen Öffnung weisen mehrere halbzylinderförmige Aussparungen auf, die leitend durchkontaktiert sind. Die Herstellung einer solchen Leiterplatte erfolgt dadurch, dass Löcher in die Leiterplatte eingebracht werden. Nach Durchkontaktieren der Löcher wird die längliche Öffnung freigeschnitten, wobei die längliche Öffnung die Löcher derart durchkreuzt, dass nach Herausschneiden der länglichen Öffnung die durchkontaktierten Löcher die Form von Halbzylindern annehmen. Anstelle einer durchgehenden Öffnung wird in der EP 0 766 507 A1 alternativ auch ein Graben zur Aufnahme des Endes des Moduls vorgeschlagen.

Nachteilig bei diesem Verfahren ist es, dass eine Vielzahl von Löchern in die Leiterplatte eingebracht werden muss, um nach einem Freischneiden eine längliche Öffnung bzw. einen Graben zur Aufnahme einer weiteren Leiterplatte zu erhalten.

Der Erfindung liegt die Aufgabe zugrunde, ein Verfahren anzugeben, welches das oben genannte Verfahren vereinfacht.

Diese Aufgabe wird durch zwei Herstellungsverfahren mit den im Anspruch 1 und Anspruch 3 angegebenen Merkmalen gelöst. Vorteilhafte Varianten und Weiterbildungen der Verfahren ergeben sich aus den abhängigen Ansprüchen 2 sowie 4 bis 10 und 11. In den Ansprüchen 12, 13 sowie 16 und 17 sind Leiterplatten angegeben, welche auf den Herstellungsverfahren nach Anspruch 1 und 3 basieren. In den Ansprüchen 14 und 18 sind Leiterplattensysteme angegeben, welche die oben genannten erfindungsgemäßen Leiterplatten sowie weitere Leiterplatten umfassen.

Bei dem erfindungsgemäßen Verfahren nach Anspruch 1 wird in kennzeichnender Weise eine schlitzförmige Öffnung mit seitlichen Ausbuchtungen in die erste Leiterplatte im Bereich der Kontaktierungsflächen als Ganzes eingebracht, um eine Klemmleiste der weiteren Leiterplatte aufnehmen zu können. Die Ausbuchtungen können z.B. halbkreisförmig sein. Die Innenseite der schlitzförmigen Öffnung wird mit einer leitfähigen Schicht überzogen, so dass eine elektrische Verbindung mit den Kontaktierungsflächen hergestellt wird. Anschließend wird die schlitzförmige Öffnung soweit verbreitert, dass die leitfähige Schicht nur noch in den Ausbuchtungen enthalten ist.

Damit ist der große Vorteil verbunden, dass die schlitzförmige Öffnung in einem Arbeitsgang hergestellt werden kann. Die Vielzahl von Bohrungen zum Erhalt der Vielzahl von Löchern und das Versehen der einzelnen Löcher mit einer Kupferschicht entfallen. Es ist lediglich noch eine geringfügige mechanische Nachbearbeitung der so geschaffenen Öffnung erforderlich, um Kurzschlussstege, die zwischen den Ausbuchtungen durch die überzogene leitfähige Schicht entstanden sind, zu entfernen.

Bei der Herstellung einer Leiterplatte werden üblicherweise in einem ersten Arbeitsschritt die Löcher für die Durchkontaktierungen zwischen den verschiedenen Lagen einer Leiterplatte gebohrt. In einem nachfolgenden Schritt wird mittels einer sogenannten "Copper-Plating-Technik" auf chemischem Wege Kupfer auf die Leiterplatte aufgebracht. Auf diese Weise werden die Löcher an ihrer Innenseite mit einem dünnen Kupferfilm überzogen. In einem anschließenden Schritt wird mittels einer galvanischen "Panel-Plating-Technik" die Schichtdicke der nun vorliegenden Kupferschicht erhöht. Die Herstellung der Leiterbahnen sowie der sogenannten Lötpads für die elektronischen Bauelemente erfolgen, indem lichtempfindlicher Fotolack durch eine Maske belichtet wird. Nach dem Entwickeln verbleibt der Fotolack an den Stellen auf der Leiterplatte, an denen das Kupfer zu entfernen ist. Der Fotolack verhindert zudem, dass sich weiteres Kupfer an diesen mit Fotolack bedeckten Stellen anreichert. Nachfolgend wird wiederum mittels der galvanischen "Panel-Plating-Technik" und einer anschließenden sogenannten "Copper-Pattern-Plating-Technik" die Kupferschicht der Leiterbahnen etc. weiter erhöht. Danach werden die Leiterbahnen, Lötpads etc. mit einer dünnen Zinnschicht versehen, welche zugleich eine Ätzmaske bildet. Nach Entfernen des Fotolacks wird die Leiterplatte geätzt, wobei das gewünschte Leiterplattenmuster verbleibt. Schließlich wird die Leiterplatte noch mit einer Lötstoppmaske versehen, welche für den nachfolgenden Lötprozess die Stellen für die Kontaktierung zu Anschlüssen der Bauelemente sowie zu externen Anschlüssen freigibt.

Vorzugsweise wird die schlitzförmige Öffnung mit den seitlichen Ausbuchtungen nach dem Aufbringen des Fotolacks in die Leiterplatte eingebracht, so dass sich beim nachfolgenden "Aufkupfern" eine Kupferschicht an der Innenseite der schlitzförmigen Öffnung absetzt. Die schlitzförmige Öffnung kann aber auch in den vorangegangenen Herstellungsschritten eingebracht werden. Auf diese Weise wird eine elektrische Verbindung von der Kupferschicht zu den Kontaktierungsflächen hergestellt. Weist zu Beginn die schlitzförmige Öffnung ohne die Ausbuchtungen z.B. noch eine Dicke von etwa 1 mm auf, so engt sich die Breite der schlitzförmigen Öffnung durch den Aufbau der Kupferschicht auf ca. 0,9 mm ein. Gemäß der Erfindung wird nun die schlitzförmige Öffnung durch Abtragen soweit verbreitert, dass die leitfähige Schicht in der schlitzförmigen Öffnung nur noch in den Ausbuchtungen enthalten ist. Durch das Abtragen werden Kurzschlussstege, die sich zwischen den Ausbuchtungen durch die angelagerte Kupferschicht ausgebildet haben, entfernt. Dabei wird auf jeder Seite der schlitzförmigen Öffnung die Kupferschicht in einem Bereich von wenigen 1/10-Millimeter, insbesondere in einem Bereich von ca. 0,3 - 0,4 mm, abgetragen.

Nachfolgend kann nun eine Klemmleiste einer weiteren Leiterplatte in die schlitzförmige Öffnung eingesteckt werden. Diese Seite kann auch als Bauteilseite, die gegenüberliegende Seite als Lötseite der Leiterplatte bezeichnet werden. Die Abmessungen der Klemmleiste sowie der schlitzförmigen Öffnung sind dabei so aufeinander abgestimmt, dass die Klemmleiste in schlitzförmige Öffnung ohne mechanische Spannungen eingepasst werden kann. Zudem ist es vorteilhaft, wenn die Klemmleiste bis zu ca. 1 - 3 mm durch die schlitzförmige Öffnung hindurchragt. Von der Lötseite aus kann nun bedingt durch die Kapillarwirkung der Ausbuchtungen Lot durch die Ausbuchtungen hindurch auf die andere Seite der Leiterplatte eindringen. Das eindringende Lot stellt nach Aushärten eine durchgängige sowie elektrische zuverlässige und mechanisch stabile Verbindung zwischen den Anschlusskontakten der Klemmleiste und den jeweiligen entsprechenden Kontaktierungsflächen auf der Leiterplatte her. Durch Adhäsion haftet vorteilhaft das Lot in Form einer Hohlnaht zwischen den Kontaktierungsflächen auf der Leiterplatte und den korrespondierenden Anschlusskontakten der Klemmleiste der weiteren Leiterplatte. Nach Erstarren bildet sich die bereits besagte äußert stabile mechanische Verbindung aus.

Bei dem erfindungsgemäßen Verfahren nach Anspruch 3 wird in kennzeichnender Weise eine schlitzförmige Vertiefung mit seitlichen Ausbuchtungen in die erste Leiterplatte im Bereich der Kontaktierungsflächen eingebracht, um eine Klemmleiste der weiteren Leiterplatte aufnehmen zu können. Die Innenseite der schlitzförmigen Vertiefung wird mit einer leitfähigen Schicht überzogen, so dass eine elektrische Verbindung mit den Kontaktierungsflächen hergestellt wird. Anschließend wird die schlitzförmige Vertiefung soweit verbreitert, dass die leitfähige Schicht nur noch in den Ausbuchtungen enthalten ist.

Dieses Herstellungsverfahren unterscheidet sich vom Herstellungsverfahren nach Anspruch 1 dadurch, dass anstelle einer schlitzförmigen Öffnung eine schlitzförmige Vertiefung in die Leiterplatte eingebracht wird. Auch dieses alternative Verfahren stellt eine elektrische zuverlässige und mechanische stabile Verbindung zwischen der Leiterplatte und einer eingesteckten und verlöteten weiteren Leiterplatte her. In diesem Sinne trifft das für erfindungsgemäße Herstellungsverfahren Gesagte nach Anspruch 1 auch auf das Herstellungsverfahren nach Anspruch 3 zu.

Für das Herstellungsverfahren nach Anspruch 1 kann in einer Verfahrensvariante die schlitzförmige Öffnung durch Stanzen in die erste Leiterplatte eingebracht werden. Durch den Stanzvorgang wird in kürzester Zeit die gewünschte schlitzförmige Öffnung in die Leiterplatte eingebracht.

Gemäß einer bevorzugten Verfahrensvariante werden die Kontaktierungsflächen in einer Reihe angeordnet, wobei die Kontaktierungsflächen mit einer Reihe von Anschlusskontakten auf der Klemmleiste der weiteren Leiterplatte korrespondieren. Dadurch lässt sich vorteilhaft eine Vielzahl von elektrischen Verbindungen zwischen der Klemmleiste und der ersten bzw. zweiten Leiterplatte herstellen.

Zum Überziehen der Innenseite der schlitzförmigen Öffnung bzw. der schlitzförmigen Vertiefung wird vorzugsweise Kupfer verwendet, welches eine hohe elektrische Leitfähigkeit und eine sehr gute Lötbarkeit aufweist.

Insbesondere wird die schlitzförmige Öffnung bzw. die schlitzförmige Vertiefung mit den seitlichen Ausbuchtungen durch Fräsen in die erste bzw. zweite Leiterplatte eingebracht. Das Fräsen erlaubt hierbei ein vorteilhaft exaktes Abtragen des Kupfer- und Leiterplattenträgermaterials.

In einer alternativen Verfahrensvariante wird die schlitzförmige Öffnung bzw. die schlitzförmige Vertiefung mit den Ausbuchtungen durch Bohren in die erste bzw. zweite Leiterplatte eingebracht. Damit ist der Vorteil verbunden, dass die gleiche Bohrvorrichtung verwendet werden kann, die auch für die Einbringung der Löcher für die Durchkontaktierungen und für Montagebohrungen benötigt wird.

In einer bevorzugten Ausführungsform wird nach Erweitern der schlitzförmigen Öffnung bzw. der schlitzförmigen Vertiefung die leitfähige Schicht auf der Innenseite verzinnt. Dadurch wird vorteilhaft die Haftung des Lots an der Kupferschicht erhöht. Zugleich bildet die verzinnte Schicht vorteilhaft eine Ätzmaske gegenüber einem nachfolgenden Ätzvorgang.

In einer weiteren bevorzugten Ausführungsform wird nach dem Verzinnen die schlitzförmige Öffnung bzw. die schlitzförmige Vertiefung mit den seitlichen Ausbuchtungen geätzt. Dadurch werden vorteilhaft nach dem Fräsen, Bohren oder Stanzen zurückgebliebene Grate und Kanten entfernt.

Wird die erste bzw. zweite Leiterplatte nach dem Ätzen mit einer Lötstoppmaske versehen, so werden nach dem Lötvorgang vorteilhaft nur die Bereiche mit Lot versehen, welche u.a. zum Anschluss der elektrischen und elektronischen Bauelemente sowie externer Anschlüsse vorgesehen sind.

Die Aufgabe der Erfindung wird weiterhin gelöst mit Verfahren zur Herstellung eines ersten bzw. zweiten Leiterplattensystems, bestehend aus einer ersten bzw. zweiten Leiterplatte und zumindest einer weiteren Leiterplatte. Dabei wird die erste bzw. zweite Leiterplatte nach dem erfindungsgemäßen Verfahren zur Herstellung der ersten bzw. zweiten Leiterplatte hergestellt. Es wird dann zumindest eine weitere Leiterplatte zusammen mit weiteren elektrischen und elektronischen Bauelementen zumindest auf einer Seite der ersten bzw. zweiten Leiterplatte fixiert. Anschließend werden die Bauelemente sowie die zumindest eine weitere Leiterplatte verlötet. Ein bekanntes Lötverfahren hierzu ist das sogenannte Schwalllöt-Verfahren.

Durch dieses Herstellungsverfahren ist ein kompaktes und ein in mechanischer und elektrischer Hinsicht äußerst stabiles Leiterplattensystem herstellbar.

Weitere vorteilhafte Eigenschaften der Erfindung ergeben sich aus deren beispielhafter Erläuterung anhand der Figuren. Es zeigt
- FIG 1: eine perspektivische Ansicht einer beispielhaften ersten Leiterplatte mit einer schlitzförmigen Öffnung mit seitlichen Ausbuchtungen gemäß der Erfindung,
- FIG 2: ein Beispiel für eine weitere Leiterplatte, welche in eine schlitzförmige Öffnung der ersten Leiterplatte gemäß FIG 1 eingesteckt werden kann,
- FIG 3: eine perspektivische Ansicht eines beispielhaften Leiterplattensystems, bestehend aus einer zweiten Leiterplatte und der weiteren Leiterplatte gemäß FIG 2,
- FIG 4: eine Schnittdarstellung der ersten Leiterplatte entsprechend einer Schnittlinie gemäß FIG 1,
- FIG 5: eine Schnittdarstellung der zweiten Leiterplatte entsprechend einer Schnittlinie gemäß FIG 3 im Bereich der Ausbuchtungen,
- FIG 6: eine Draufsicht auf die erste Leiterplatte gemäß FIG 1 nach Einbringung der schlitzförmigen Öffnung mit den seitlichen Ausbuchtungen gemäß der Erfindung,
- FIG 7: eine Draufsicht auf die erste Leiterplatte gemäß FIG 1 nach Überziehen der Innenseite der schlitzförmigen Öffnung mit den seitlichen Ausbuchtungen mit einer leitfähigen Schicht gemäß der Erfindung,
- FIG 8: eine Draufsicht auf die erste Leiterplatte gemäß FIG 1 nach Erweitern der schlitzförmigen Öffnung mit den seitlichen Ausbuchtungen gemäß der Erfindung, und
- FIG 9: eine Schnittdarstellung durch den Kreuzungsbereich einer ersten Leiterplatte und einer weiteren Leiterplatte.

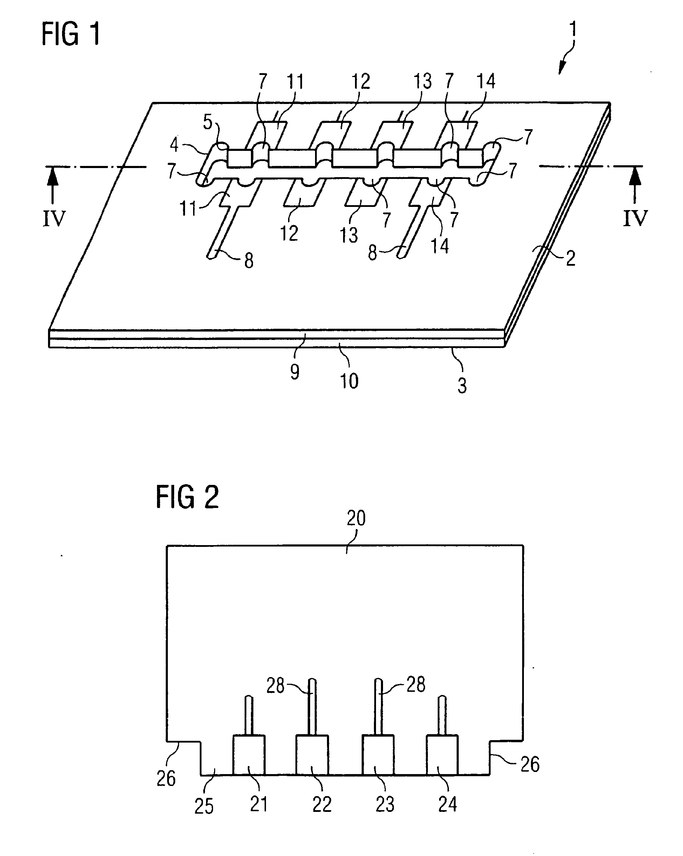

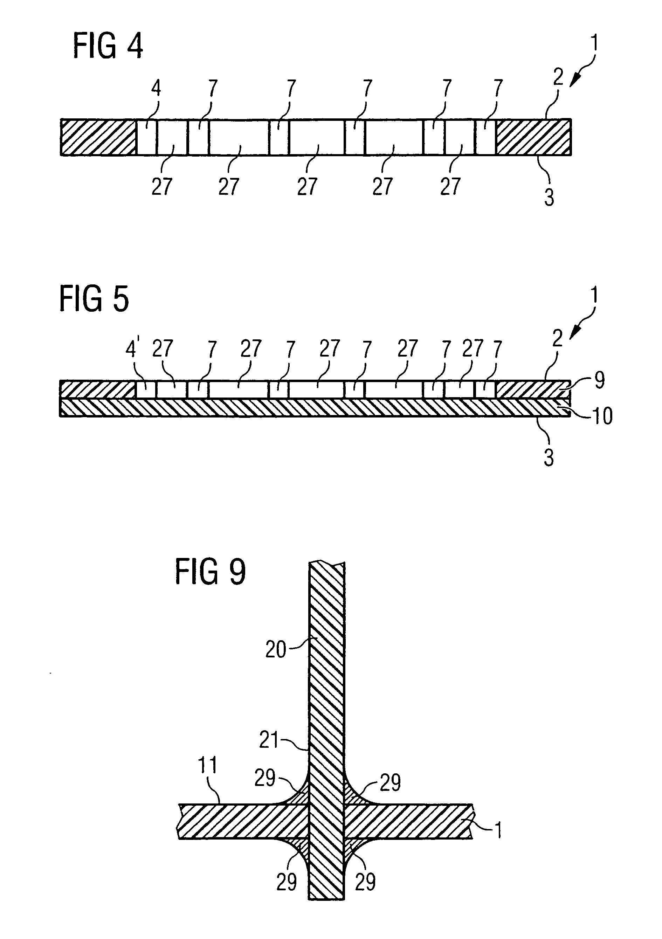

FIG 1 zeigt eine perspektivische Ansicht einer beispielhaften ersten Leiterplatte 1 mit einer schlitzförmigen Öffnung 4 mit seitlichen Ausbuchtungen 7 gemäß der Erfindung. Aus Gründen der Übersichtlichkeit wurde dabei auf eine detaillierte Darstellung der elektronischen Bauelemente und der Leiterbahnen 8 auf der ersten Leiterplatte 1 verzichtet. Mit dem Bezugszeichen 11-14 sind die Kontaktierungsflächen bezeichnet, welche letztendlich nach Einbringung der schlitzförmigen Öffnung 4 acht Kontaktierungspunkte zum möglichen elektrischen Anschluss bilden. Deutlich ist auch die Fortsetzung der Kontaktierungsflächen 11-14 in den Seitenwandbereich 5 der schlitzförmigen Öffnung 4 hinein zu sehen. Im Beispiel der FIG 1 weist die schlitzförmige Öffnung 4 beispielhaft halbkreisförmige Ausbuchtungen 7 auf. Andere Formen, wie z.B. rechteckförmige Aussparungen mit abgerundeten Ecken, sind ebenfalls möglich. Benachbarte Ausbuchtungen 7 sind je über gerade Teilstücke 27 miteinander verbunden. Dies schließt auch den linken und rechten Endbereich der schlitzförmigen Öffnung 4 mit ein, so dass dort die weitere Leiterplatte 20 exakt plan eingepasst werden kann. In FIG 4 ist die zugehörige Schnittdarstellung der ersten Leiterplatte 1 gemäß der in FIG 1 eingetragenen Schnittlinie gezeigt. Die FIG 4 zeigt auch die Ausbuchtungen 7 sowie die diese umgebenden gerade Teilstücke 27. Mit dem Bezugszeichen 2 ist ferner die obere Lage, mit dem Bezugszeichen 3 die untere Lage der Leiterplatte 1 bezeichnet.

FIG 2 zeigt ein Beispiel für eine weitere Leiterplatte 20, welche in die schlitzförmige Öffnung 4 der ersten Leiterplatte 1 gemäß FIG 1 eingesteckt werden kann. Aus Gründen der Übersichtlichkeit wurde wiederum auf eine detaillierte Darstellung elektronischen Bauelementen und Leiterbahnen 28 auf der weiteren Leiterplatte 20 verzichtet. Die Leiterbahnen 28 sind beispielhaft nur als Ansatz dargestellt. Die weitere Leiterplatte 20 weist eine Klemmleiste 25 im unteren Bereich auf. Im seitlichen Bereich weist die weitere Leiterplatte 20 je eine Aussparung 26 auf. Auf diese Weise kann die weitere Leiterplatte 20 in der schlitzförmigen Öffnung 4 fixiert werden, ohne dass diese durch die schlitzförmige Aussparung "durchfallen" kann.

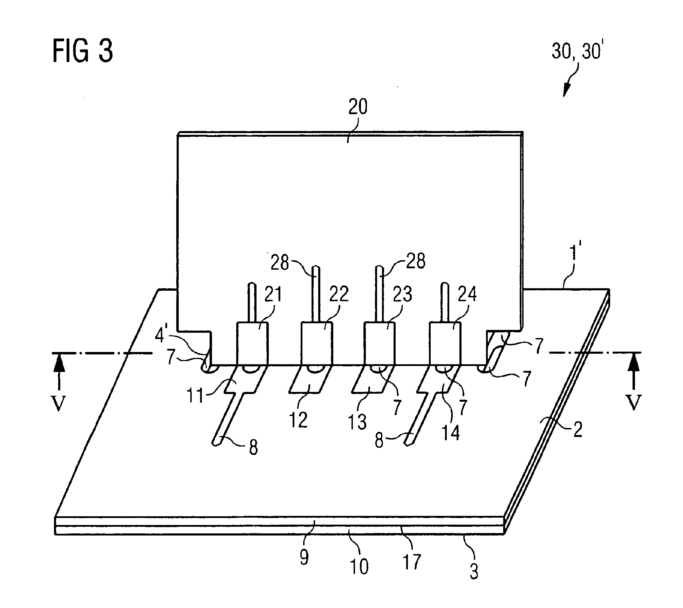

FIG 3 eine perspektivische Ansicht eines beispielhaften Leiterplattensystems 30', bestehend aus einer zweiten Leiterplatte 1' und der weiteren Leiterplatte gemäß FIG 2. Das Bezugszeichen 30 bezeichnet ein Leiterplattensystem für den Fall, dass die weitere Leiterplatte 20 in eine erste Leiterplatte 1 gemäß den Figuren 1 und 2 eingesteckt würde. Die weitere Leiterplatte 20 ist im Beispiel der FIG 3 senkrecht in eine schlitzförmige Vertiefung 4' eingesteckt, wobei auch andere Einsteckwinkel denkbar sind. Zugleich handelt es sich bei der zweiten Leiterplatte 20 um eine beispielhaft dreilagige Mehrlagenleiterplatte 20 mit einer oberen und unteren Lage 10,9 sowie einer dazwischen liegenden mittleren Lage 17.

Die zugehörige Schnittdarstellung der zweiten Leiterplatte 1' gemäß der in FIG 3 eingetragenen Schnittlinie ist in FIG 5 dargestellt. Die Schnittlinie erstreckt sich im Bereich der Ausbuchtungen 7. Die FIG 5 zeigt dabei im Detail die Tiefe der schlitzförmigen Vertiefung 4' zur Aufnahme der zweiten Leiterplatte 1'. Die Tiefe entspricht hier beispielhaft der Dicke der Lage 9 der dreilagigen zweiten Leiterplatte l'. Wie die FIG 3 weiterhin zeigt, liegen im Kniebereich zwischen den beiden Leiterplatten 1',20 die Kontaktierungsflächen 11-14 in direkter Nachbarschaft zu den entsprechenden Anschlusskontakten 21-24 der Klemmleiste 25 der weiteren Leiterplatte 20. Im Falle einer Lötung werden die Kontaktierungsflächen 11-14 dann mit den jeweiligen Anschlusskontakten 21-24 sowohl elektrisch als auch mechanisch fest verbunden. Wie zuvor beschrieben, wird dies durch die Kapillarwirkung der Ausbuchtungen 7 bewirkt. Die Schnittdarstellung durch den Kreuzungsbereich der Kontaktierungsfläche 11 und des korrespondierenden Anschlusskontakts 21 der ersten Leiterplatte 1 sowie der weiteren Leiterplatte 20 zeigt dies im Detail. Mit dem Bezugszeichen 29 sind Lötstellen bezeichnet, welche durch Adhäsion die Form einer Hohlnaht annehmen.

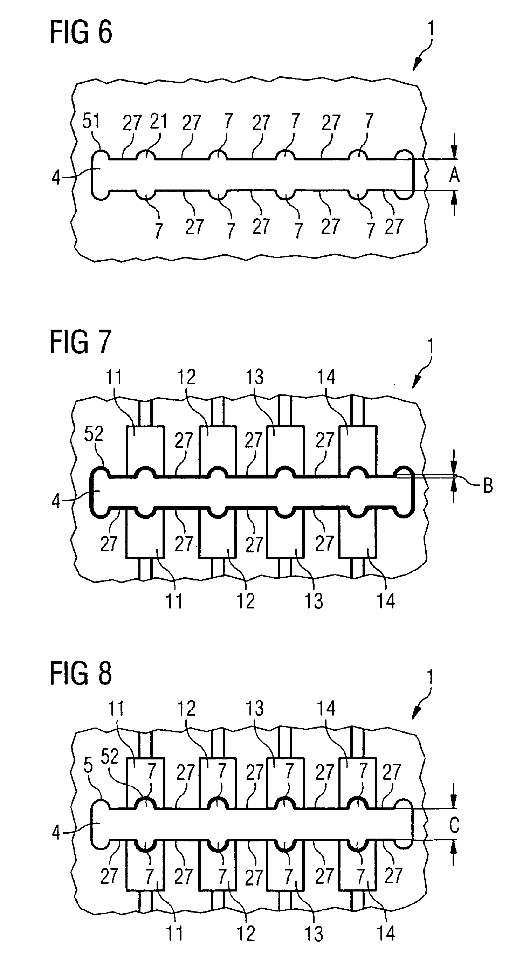

FIG 6 zeigt eine Draufsicht auf die erste Leiterplatte 1 gemäß FIG 1 nach Einbringung der schlitzförmigen Öffnung 4 mit den seitlichen Ausbuchtungen 7 gemäß der Erfindung. Die schlitzförmige Öffnung 4 bildet dabei die beispielhaft dargestellte Konturlinie 52 aus. Mit A ist die ursprüngliche Breite der schlitzförmigen Öffnung 4 bezeichnet, wobei die Ausdehnung der Ausbuchtungen 7 nicht mit eingerechnet wird. Das Einbringen der schlitzförmigen Öffnung 4 kann z.B. mittels eines Fräskopfes mit kreisförmiger Querschnittsfläche erfolgen, wobei der Durchmesser der Querschnittsfläche mit dem der halbkreisförmigen Ausbuchtungen 7 übereinstimmt. Der Fräskopf kann z.B. entlang der Konturlinie 51 in FIG 6 rechts- oder linksumlaufend so bewegt werden, dass die schlitzförmige Öffnung 4 mit den seitlichen Ausbuchtungen 7 entsteht.

FIG 7 zeigt nun eine Draufsicht auf die erste Leiterplatte 1 nach Überziehen der Innenseite 5 der schlitzförmigen Öffnung 4 mit einer leitfähigen Schicht 52. Die leitfähige Schicht 52 ist insbesondere eine Kupferschicht, die mittels der eingangs vorgestellten Techniken aufgebaut worden ist. Die Kupferschicht weist dabei eine Dicke B auf. Typische Werte für die Dicke B liegen im Bereich von weniger als 1/10-Millimeter.

FIG 8 zeigt eine Draufsicht auf die erste Leiterplatte 1 gemäß FIG 1 nach Erweitern der schlitzförmigen Öffnung 4 mit den seitlichen Ausbuchtungen 7 gemäß der Erfindung. Durch Abtragen der Kupferschicht 52 und ggf. des Leiterplattenträgermaterials weist die schlitzförmige Öffnung 4 insbesondere eine geringfügig größere Breite C im Vergleich zur ursprünglichen Breite A auf. Die FIG 8 zeigt zudem, dass gemäß der Erfindung nur noch in den Ausbuchtungen 7 die leitfähige Kupferschicht 52 zu finden ist. Die gemäß FIG 7 ausgebildeten Kurzschlussstege 27 wurden dabei durch die Erweiterung der schlitzförmigen Öffnung 4 entfernt.

## Patentansprüche

1. Verfahren zur Herstellung einer ersten Leiterplatte (1), welche zur Aufnahme einer weiteren Leiterplatte (20) bestimmt ist, wobei das Verfahren u.a. Schritte zur Aufbringung von Kontaktierungsflächen (11-14) auf der ersten Leiterplatte (1) einschließt,
**dadurch gekennzeichnet,**
a) **dass** eine schlitzförmige Öffnung (4) mit seitlichen Ausbuchtungen (7) in die erste Leiterplatte (1) im Bereich der Kontaktierungsflächen (11-14) als Ganzes eingebracht wird, um eine Klemmleiste (25) der weiteren Leiterplatte (20) aufnehmen zu können,
b) **dass** die Innenseite (5) der schlitzförmigen Öffnung (4) mit einer leitfähigen Schicht (52) überzogen wird, so dass eine elektrische Verbindung mit den Kontaktierungsflächen (11-14) hergestellt wird, und
c) **dass** die schlitzförmige Öffnung (4) soweit verbreitert wird, dass die leitfähige Schicht (52) nur noch in den Ausbuchtungen (7) enthalten ist.

2. Herstellungsverfahren nach Anspruch 1,
**dadurch gekennzeichnet,**
**dass** im Verfahrensschritt a) die schlitzförmige Öffnung (4) mit den seitlichen Ausbuchtungen (7) durch Stanzen in die erste Leiterplatte (1) eingebracht wird.

3. Verfahren zur Herstellung einer zweiten Leiterplatte (1'), welche zur Aufnahme einer weiteren Leiterplatte (20) bestimmt ist, wobei das Verfahren u.a. Schritte zur Aufbringung von Kontaktierungsflächen (11-14) auf der zweiten Leiterplatte (1') einschließt,
**dadurch gekennzeichnet,**
a) **dass** eine schlitzförmige Vertiefung (4') mit seitlichen Ausbuchtungen (7) in die zweite Leiterplatte (1) im Bereich der Kontaktierungsflächen (11-14) als Ganzes eingebracht wird, um eine Klemmleiste (25) der weiteren Leiterplatte (20) aufnehmen zu können,
b) **dass** die Innenseite (5) der schlitzförmigen Vertiefung (4') mit einer leitfähigen Schicht (52) überzogen wird, so dass eine elektrische Verbindung mit den Kontaktierungsflächen (11-14) hergestellt wird, und
c) **dass** die schlitzförmige Vertiefung (4') soweit verbreitert wird, dass die leitfähige Schicht (52) nur noch in den Ausbuchtungen (7) enthalten ist.

4. Herstellungsverfahren nach einem der vorigen Ansprüche,
**dadurch gekennzeichnet,**
**dass** die Kontaktierungsflächen (11-14) in einer Reihe angeordnet sind, wobei die Kontaktierungsflächen (11-14) mit einer Reihe von Anschlusskontakten (21-24) auf der Klemmleiste (25) der weiteren Leiterplatte (20) korrespondieren.

5. Herstellungsverfahren nach einem der vorigen Ansprüche,
**dadurch gekennzeichnet,**
**dass** zum Überziehen der Innenseite (5) der schlitzförmigen Öffnung (4) bzw. schlitzförmigen Vertiefung (4') mit den seitlichen Ausbuchtungen (7) Kupfer verwendet wird.

6. Herstellungsverfahren nach einem der vorigen Ansprüche,
**dadurch gekennzeichnet,**
**dass** die schlitzförmige Öffnung (4) bzw. schlitzförmige Vertiefung (4') mit den seitlichen Ausbuchtungen (7) durch Fräsen in die erste bzw. zweite Leiterplatte (1,1') eingebracht wird.

7. Herstellungsverfahren nach einem der vorigen Ansprüche,
**dadurch gekennzeichnet,**
**dass** die schlitzförmige Öffnung (4) bzw. schlitzförmige Vertiefung (4') mit den seitlichen Ausbuchtungen (7) durch Bohren in die erste bzw. zweite Leiterplatte (1,1') eingebracht wird.

8. Herstellungsverfahren nach einem der vorigen Ansprüche,
**dadurch gekennzeichnet,**
**dass** nach Verbreitern der schlitzförmigen Öffnung (4) bzw. der schlitzförmigen Vertiefung (4') die leitfähige Schicht (52) auf der Innenseite (5) verzinnt wird.

9. Herstellungsverfahren nach Anspruch 8,
**dadurch gekennzeichnet,**
**dass** nach dem Verzinnen die schlitzförmige Öffnung (4) bzw. die schlitzförmige Vertiefung (4') mit den seitlichen Ausbuchtungen (7) geätzt wird.

10. Herstellungsverfahren nach Anspruch 9,
**dadurch gekennzeichnet,**
**dass** die erste bzw. zweite Leiterplatte (1,1') nach dem Ätzen mit einer Lötstoppmaske versehen wird.

11. Verfahren zur Herstellung eines ersten Leiterplattensystems (30), bestehend aus einer ersten Leiterplatte (1) und zumindest einer weiteren Leiterplatte (20), wobei
a) die erste Leiterplatte (1) gemäß einem Verfahren nach zumindest Anspruch 1 hergestellt wird,
b) die zumindest eine weitere Leiterplatte (20) zusammen mit weiteren elektrischen und elektronischen Bauelementen zumindest auf einer Seite (2,3) der ersten Leiterplatte (1) fixiert wird, und
c) die Bauelemente sowie die zumindest eine weitere Leiterplatte (20) verlötet werden.

12. Erste Leiterplatte (1) mit einer schlitzförmigen Öffnung (4) zur Aufnahme einer weiteren Leiterplatte (20), hergestellt gemäß einem Verfahren nach zumindest Anspruch 1.

13. Erste Leiterplatte (1) nach Anspruch 12,
**dadurch gekennzeichnet,**
**dass** die erste Leiterplatte (1) eine Mehrlagenleiterplatte (9,10,17) ist.

14. Erstes Leiterplattensystem (30), welches eine erste Leiterplatte (1) nach Anspruch 12 oder 13 und zumindest eine weitere in je eine schlitzförmige Öffnung (4) der ersten Leiterplatte (1) eingesteckte und verlötete Leiterplatte (20) aufweist.

15. Verfahren zur Herstellung eines zweiten Leiterplattensystems (30'), bestehend aus einer zweiten Leiterplatte (1') und zumindest einer weiteren Leiterplatte (20), wobei
a) die zweite Leiterplatte (1') gemäß einem Verfahren nach zumindest Anspruch 3 hergestellt wird,
b) die zumindest eine weitere Leiterplatte (20) zusammen mit weiteren elektrischen und elektronischen Bauelementen zumindest auf einer Seite (2,3) der zweiten Leiterplatte (1') fixiert wird und
c) die Bauelemente sowie die zumindest eine weitere Leiterplatte (20) verlötet werden.

16. Zweite Leiterplatte (1') mit einer schlitzförmigen Vertiefung (4') zur Aufnahme einer weiteren Leiterplatte (20), hergestellt gemäß einem Verfahren nach zumindest Anspruch 3.

17. Zweite Leiterplatte (1') nach Anspruch 15,
**dadurch gekennzeichnet,**
**dass** die zweite Leiterplatte (1') eine Mehrlagenleiterplatte (9,10,17) ist.

18. Zweites Leiterplattensystem (30'), welches eine zweite Leiterplatte (1') nach Anspruch 16 oder 17 und zumindest eine weitere in je eine schlitzförmige Vertiefung (4') der zweiten Leiterplatte (1') eingesteckte und verlötete Leiterplatte (20) aufweist.

## Claims

1. Method for manufacturing a first printed circuit board (1) which is intended for receiving a further printed circuit board (20), the method including, inter alia, steps for applying contact surfaces (11-14) on the first printed circuit board (1),
**characterised in that**
a) a slot-shaped aperture (4) with side bulges (7) is introduced into the first printed circuit board (1) in the area of the contact surfaces (11-14) as a whole in order to be able to receive a terminal strip (25) of the further printed circuit board (20),
b) the inner side (5) of the slot-shaped aperture (4) is coated with a conductive layer (52) so that an electrical connection is made with the contact surfaces (11-14) and
c) the slot-shaped aperture (4) is widened to the extent that the conductive layer (52) is only contained in the bulges (7) .

2. Manufacturing method according to claim 1,
**characterised in that**
the slot-shaped aperture (4) with the side bulges (7) is introduced into the first printed circuit board (1) by means of stamping in method step a).

3. Method for manufacturing a second printed circuit board (1') which is intended for receiving a further printed circuit board (20), the method including, inter alia, steps for applying contact surfaces (11-14) on the second printed circuit board (1'),
**characterised in that**
a) a slot-shaped depression (4') with side bulges (7) is introduced into the second printed circuit board (1) in the area of the contact surfaces (11-14) as a whole in order to be able to receive a terminal strip (25) of the further printed circuit board (20),
b) the inner side (5) of the slot-shaped depression (4') is coated with a conductive layer (52) so that an electrical connection is made with the contact surfaces (11-14) and
c) the slot-shaped depression (4') is widened to the extent that the conductive layer (52) is only contained in the bulges (7).

4. Manufacturing method according to one of the foregoing claims,
**characterised in that**
the contact surfaces (11-14) are arranged in a row, the contact surfaces (11-14) corresponding to a row of connection contacts (21-24) on the terminal strip (25) of the further printed circuit board (20).

5. Manufacturing method according to one of the foregoing claims,
**characterised in that**
copper is used for coating the inner side (5) of the slot-shaped aperture (4) or slot-shaped depression (4') with the side bulges (7).

6. Manufacturing method according to one of the foregoing claims,
**characterised in that**
the slot-shaped aperture (4) or slot-shaped depression (4') with the side bulges (7) is introduced into the first or second printed circuit board (1, 1') by means of milling.

7. Manufacturing method according to one of the foregoing claims,
**characterised in that**
the slot-shaped aperture (4) or slot-shaped depression (4') with the side bulges (7) is introduced into the first or second printed circuit board (1, 1') by means of drilling.

8. Manufacturing method according to one of the foregoing claims,
**characterised in that**
after widening of the slot-shaped aperture (4) or the slot-shaped depression (4'), the conductive layer (52) is tin-coated on the inner side (5).

9. Manufacturing method according to claim 8,
**characterised in that**
after the tin-coating, the slot-shaped aperture (4) or the slot-shaped depression (4') with the side bulges (7) is etched.

10. Manufacturing method according to claim 9,
**characterised in that**
after the etching, the first or second printed circuit board (1, 1') is provided with a solder mask.

11. Method for manufacturing a first printed circuit board system (30) consisting of a first printed circuit board (1) and at least one further printed circuit board (20),
a) the first printed circuit board (1) being manufactured as defined by a method according to at least claim 1,
b) said at least one further printed circuit board (20) being fixed, together with further electrical and electronic components, at least on one side (2, 3) of the first printed circuit board (1) and
c) the components and also said at least one further printed circuit board (20) being soldered together.

12. First printed circuit board (1) with a slot-shaped aperture (4) for receiving a further printed circuit board (20), manufactured as defined by a method according to at least claim 1.

13. First printed circuit board (1) according to claim 12,
**characterised in that**
the first printed circuit board (1) is a multilayer printed circuit board (9, 10, 17).

14. First printed circuit board system (30) which has a first printed circuit board (1) according to claim 12 or 13 and at least one further printed circuit board (20) inserted into one slot-shaped aperture (4) of the first printed circuit board (1) in each case and soldered.

15. Method for manufacturing a second printed circuit board system (30') consisting of a second printed circuit board (1') and at least one further printed circuit board (20),
a) the second printed circuit board (1') being manufactured as defined by a method according to at least claim 3,
b) said at least one further printed circuit board (20) being fixed, together with further electrical and electronic components, at least on one side (2, 3) of the second printed circuit board (1') and
c) the components and also said at least one further printed circuit board (20) being soldered together.

16. Second printed circuit board (1') with a slot-shaped depression (4') for receiving a further printed circuit board (20), manufactured as defined by a method according to at least claim 3.

17. Second printed circuit board (1') according to claim 15,
**characterised in that**
the second printed circuit board (1') is a multilayer printed circuit board (9, 10, 17).

18. Second printed circuit board system (30') which has a second printed circuit board (1') according to claim 16 or 17 and at least one further printed circuit board (20) inserted into one slot-shaped depression (4') of the second printed circuit board (1') in each case and soldered.

## Revendications

1. Procédé de production d'une première carte (1) à circuit imprimé, qui est conçue pour la réception d'une autre carte (20) à circuit imprimé, le procédé comprenant, entre autres, des stades de dépôt de surfaces (11 à 14) de mise en contact sur la première carte (1) à circuit imprimé,
**caractérisé**
a) **en ce que** l'on ménage en entier une ouverture (4) en forme de fente ayant des indentations (7) latérales dans la première carte (1) à circuit imprimé dans la zone des surfaces (11 à 14) de mise en contact, afin de pouvoir recevoir une barrette (25) de bornes de l'autre carte (20) à circuit imprimé,
b) **en ce que** l'on revêt la face (5) intérieure de l'ouverture (4) en forme de fente d'une couche (52) conductrice, de manière à ménager une liaison électrique avec les surfaces (11 à 14) de mise en contact et
c) **en ce que** l'on élargit tellement l'ouverture (4) en forme de fente que la couche (52) conductrice n'est plus contenue que dans les indentations.

2. Procédé de production suivant la revendication 1,
**caractérisé**
**en ce qu'**au stade a) du procédé, on ménage l'ouverture (4) en forme de fente ayant les indentations (7) latérales par estampage dans la première carte (1) à circuit imprimé.

3. Procédé de production d'une deuxième carte (1') à circuit imprimé, qui est destinée à recevoir une autre carte (20) à circuit imprimé, le procédé comprenant, en outre, des stades de dépôt de surfaces (11 à 14) de mise en contact sur la deuxième carte (1') à circuit imprimé,
**caractérisé**
a) **en ce que** l'on ménage dans son entier une cavité (4') en forme de fente ayant des indentations (7) latérales, dans la deuxième carte (1) à circuit dans la zone des surfaces (11 à 14) de mise en contact afin de pouvoir recevoir une barrette (25) de bornes de l'autre carte (20) à circuit imprimé,
b) **en ce que** l'on revêt la face (5) intérieure de l'ouverture (4) en forme de fente d'une couche (52) conductrice, de manière à ménager une liaison électrique avec les surfaces (11 à 14) de mise en contact et
c) **en ce que** l'on élargit tellement la cavité (4') en forme de fente que la couche (52) conductrice n'est plus contenue que dans les indentations (7).

4. Procédé de production suivant l'une des revendications précédentes,
**caractérisé**
**en ce que** les surfaces (11 à 14) de mise en contact sont disposées suivant une rangée, les surfaces (11 à 14) de mise en contact correspondant avec une rangée de contacts (21 à 24) de bornes sur la barrette (25) de bornes de l'autre carte (20) à circuit imprimé.

5. Procédé de production suivant l'une des revendications précédentes,
**caractérisé**
**en ce que** pour revêtir la face (5) intérieure de l'ouverture (4) en forme de fente ou de la cavité (4') en forme de fente ayant les indentations (7) latérales, on utilise du cuivre.

6. Procédé de production suivant l'une des revendications précédentes,
**caractérisé**
**en ce que** l'on ménage l'ouverture (4) en forme de fente ou la cavité (4') en forme de fente ayant les indentations (7) latérales par fraisage dans la première ou la deuxième carte (1, 1') à circuit imprimé.

7. Procédé de production suivant l'une des revendications précédentes,
**caractérisé**
**en ce que** l'on ménage l'ouverture (4) en forme de fente ou la cavité (4') en forme de fente ayant les indentations (7) latérales par perçage dans la première ou la deuxième carte (1, 1') à circuit imprimé.

8. Procédé de production suivant l'une des revendications précédentes,
**caractérisé**
**en ce qu'**après l'élargissement de l'ouverture (4) en forme de fente ou de la cavité (4') en forme de fente on étame la couche (52) conductrice sur la face (5) intérieure.

9. Procédé de production suivant la revendication 8,
**caractérisé**
**en ce qu'**après l'étamage, on attaque l'ouverture (4) en forme de fente ou la cavité (4') en forme de fente ayant les indentations (7) latérales.

10. Procédé de production suivant la revendication 9,
**caractérisé**
**en ce que** l'on munit la première ou la deuxième carte (1, 1') à circuit imprimé après l'attaque d'un masque d'arrêt de brasure.

11. Procédé de production d'un premier système (30) de cartes à circuits imprimés constitué d'une première carte (1) à circuit imprimé et d'au moins une autre carte (20) à circuit imprimé, dans lequel
a) on produit la première carte (1) à circuit imprimé par un procédé suivant au moins la revendication 1,
b) on immobilise la au moins une autre carte (20) à circuit imprimé ensemble avec d'autres composants électriques et électroniques au moins sur une face (2, 3) de la première carte (1) à circuit imprimé, et
c) on brase les composants ainsi que la au moins une autre carte (20) à circuit imprimé.

12. Première carte (1) à circuit imprimé ayant une ouverture (4) en forme de fente de réception d'une autre carte (20) à circuit imprimé produite par un procédé suivant au moins la revendication 1.

13. Première carte (1) à circuit imprimé suivant la revendication 12,
**caractérisée**
**en ce que** la première carte (1) à circuit imprimé est une carte (9, 10, 17) à circuit imprimé à plusieurs strates.

14. Premier système (30) de cartes à circuits imprimés, qui a une première carte (1) à circuit imprimé suivant la revendication 12 ou 13 et au moins une autre carte (20) à circuit imprimé brasée et enfichée dans, respectivement, une ouverture (4) en forme de fente de la première carte (1) à circuit imprimé.

15. Procédé de production d'un deuxième système (30') de cartes à circuits imprimés, constitué d'une deuxième carte (1') à circuit imprimé et d'au moins une autre carte (20) à circuit imprimé, dans lequel
a) on produit la deuxième carte (1') à circuit imprimé suivant un procédé selon au moins la revendication 3,
b) on immobilise la au moins une autre carte (20) à circuit imprimé ensemble avec d'autres composants électriques et électroniques au moins sur une face (2, 3) de la deuxième carte (1') à circuit imprimé et
c) on brase les composants ainsi que la au moins une autre carte (20) à circuit imprimé.

16. Deuxième carte (1') à circuit imprimé ayant une cavité (4') en forme de fente de réception d'une autre carte (20) à circuit imprimé produite par un procédé suivant au moins la revendication 3.

17. Deuxième carte (1') à circuit imprimé suivant la revendication 15,
**caractérisée**
**en ce que** la deuxième carte (1') à circuit imprimé est une carte (9, 10, 17) à circuit imprimé à plusieurs strates.

18. Deuxième système (30') de cartes à circuits imprimés, qui a une deuxième carte (1') à circuit imprimé suivant la revendication 16 ou 17 et au moins une autre carte (20) à circuit imprimé brasée et enfichée dans, respectivement, une cavité (4') en forme de fente de la deuxième carte (1') à circuit imprimé.
